# EUROPEAN PATENT SPECIFICATION

(11) **EP 3 541 153 B1**
(45) Date of publication and mention of the grant of the patent: **18.10.2023**
(21) Application number: 19162858.5
(22) Date of filing: 14.03.2019
(51) Int. Cl.: H05K 1/14, H01H 71/02, H01H 71/12, H01H 83/02, H01H 83/22, H05K 3/46

(54) **FLEXIBLE CIRCUIT BOARD AND CIRCUIT BREAKER USING A FLEXIBLE PRINTED CIRCUIT BOARD**
FLEXIBLE LEITERPLATTE UND SCHUTZSCHALTER MIT EINER FLEXIBLEN LEITERPLATTE
CARTE DE CIRCUIT IMPRIMÉ SOUPLE ET UN DISJONCTEUR COMPORTANT UNE TELLE CARTE DE CIRCUIT IMPRIMÉ SOUPLE

(30) Priority: 16.03.2018 CN 201810220844
(43) Date of publication of application: 18.09.2019
(73) Proprietor: Siemens Aktiengesellschaft, 80333 München (DE)
(72) Inventor: Hu, Chang Chun, Shanghai 201602 (CN); Martel, Jean-Mary, 93105 Tegernheim (DE); Nörl, Gerald, 93133 Burglengenfeld (DE); Xu, Yan Yan, Shanghai 201805 (CN); Mao, He Lian, Taizhou, Zhejiang Province 317105 (CN)
(74) Representative: Siemens Patent Attorneys

(56) References cited:
- JP-A- S59 171 427
- JP-A- 2005 166 274
- JP-A- 2010 225 311
- US-A- 3 706 916
- US-A- 5 428 190
- US-A1- 2005 073 820
- US-A1- 2007 184 680
- US-A1- 2010 149 772
- US-A1- 2015 261 265

## Description

### Technical field

The present invention relates to the field of circuit board design, in particular a flexible circuit board and a circuit breaker thereof.

### Background art

A printed circuit board (+ Assembly, with English abbreviation PCBA) is a provider of electrical connections for electronic components. Since it is made using electronic printing technology, it is called a "printed" circuit board. Before the emergence of printed circuit boards, all connections between electronic elements relied on direct wire connections to form a complete circuit. The main advantage of using a circuit board is that errors in wiring and assembly are greatly reduced, while the level of automation and the production labor rate are increased.

A circuit breaker is generally a switch apparatus for current. It consists of a contact system, an arc-extinguishing system, an operating mechanism, a trip unit and a housing, etc. When a short circuit occurs, a magnetic field generated by a large current (generally 10 to 12 times) overcomes a counter-force spring, the trip unit pulls the operating mechanism to act, and the switch is tripped instantaneously. When an overload occurs, the current increases, the amount of heat emitted intensifies, and a bimetallic strip deforms to a certain extent and pushes a mechanism to act (the greater the current, the shorter the action time). A circuit board will also be disposed in the design of a circuit breaker, but existing circuit breaker circuit boards still have many design problems which are in urgent need of a solution.

US 20100149772 A1 discloses a circuit breaker including a housing, a rigid circuit board, and a flexible circuit board. The rigid circuit board is enclosed within the housing and has a main surface for supporting an electronic component. The flexible circuit board has a first end that is directly attached to an edge of the rigid circuit board.

Furthermore, those skilled in the art are still striving to find other circuit board design solutions.

### Content of the invention

The invention is set out in the appended set of claims.

The present application provides a flexible circuit board and a circuit breaker thereof, to solve the technical problem that an entire conventional circuit board cannot be designed when it is subject to space restrictions.

The flexible circuit board provided in the present application comprises multiple circuit boards and at least one flexible connecting member; the circuit boards are hard circuit boards. The flexible connecting member is connected between the independent multiple circuit boards, such that the multiple circuit boards form a circuit board connected by the flexible connecting member, the flexible connecting member being bent such that the multiple circuit boards form a three-dimensional spatial layout.

It can be seen that the flexible circuit board of the present application is different from an entire circuit board in the prior art; the three-dimensional spatial layout is formed by the connection and bending of the flexible connecting member. A creepage distance and electrical gap between the circuit boards can be ensured. In addition, a specific three-dimensional spatial layout structure can be designed according to the needs of installation and manufacture.

A connection circuit is disposed on the flexible connecting member; the connection circuit connects internal circuits of the multiple circuit boards, i.e. the flexible connecting member is used for electrical connection. In other words, the flexible connecting member is not only able to perform connection in a physical structural sense alone. In addition, it is also possible to use an electrical connection to connect circuits between the multiple circuit boards.

The multiple circuit boards comprise a control circuit board and a power supply circuit board, and an auxiliary function circuit board. The at least one flexible connecting member comprises a first flexible connecting member, two ends of the first flexible connecting member being connected to the control circuit board and the power supply circuit board respectively. Two ends of the second flexible connecting member are connected to the control circuit board and the auxiliary function circuit board respectively. This embodiment provides a specific circuit board connection structure.

The control circuit board and the power supply circuit board are disposed opposite and parallel to each other; optionally, the auxiliary function circuit board is disposed between the control circuit board and the power supply circuit board, and is arranged perpendicular to the control circuit board and the power supply circuit board. This arrangement provides a three-dimensional spatial layout based on the abovementioned circuit board connection structure.

In an optional embodiment, the present application also provides a circuit breaker using a flexible circuit board, comprising the flexible circuit board as described above and a base, the multiple circuit boards being fixed at different spatial positions on the base, such that the multiple circuit boards form a three-dimensional spatial layout. This embodiment discloses a structure of application of the flexible circuit board in a circuit breaker.

In another optional embodiment, the flexible connecting member is a thin-plate structure, the flexible connecting member being arranged in a close fit with a surface of the base. This is in order to minimize the space occupied by the flexible connecting member on the base. This embodiment provides a specific structure of the flexible connecting member for the purpose of reducing the space occupied by the flexible connecting member.

In another optional embodiment, the base is provided with at least one slot-type channel, the slot-type channel being disposed on the base or surface with which the flexible connecting member is arranged in a close fit, and the slot-type channel being used to accommodate the flexible connecting member. This embodiment provides a technical solution for the purpose of providing space in which to arrange the slot-type channel, in order to further reduce the space occupied by the flexible connecting member.

In another optional embodiment, multiple accommodating spaces with outward-facing openings are disposed on surfaces at different spatial positions of the base; the multiple circuit boards are disposed in the multiple accommodating spaces respectively and located by means of locating structures; communication ports are disposed on sidewalls of the accommodating spaces for the purpose of passing through and connecting the flexible connecting member. The circuit breaker further comprises at least one housing, the housing being fastened to the base, so that the housing closes the openings of the accommodating spaces to form closed chambers to accommodate the circuit boards. This embodiment provides a specific manner of connecting the flexible circuit board to the circuit breaker.

In another optional embodiment, a slot-type channel is disposed on an inner wall of the housing, in a position corresponding to the flexible connecting member; the slot-type channel is used to accommodate the flexible connecting member. This embodiment provides a technical solution in which, in addition to having a slot-type channel disposed on the base, a slot-type channel may also be disposed on an inner wall of the housing.

In another optional embodiment, the multiple accommodating spaces are disposed on two opposite outer surfaces of the base respectively. The at least one housing further comprises a first housing and a second housing, the first housing and the second housing being fastened to the two opposite outer surfaces respectively, with inner walls of the first housing and the second housing abutting the openings of the accommodating spaces to form the closed chambers. This embodiment further discloses a layout and connection structure of the housing and base, and the flexible circuit board.

### Description of the accompanying drawings

Preferred embodiments of the present invention are described in detail below by referring to the accompanying drawings, to give those skilled in the art a clearer understanding of the abovementioned and other features and advantages of the present invention. In the drawings:
Fig. 1 is a three-dimensional structural schematic diagram of the spatial layout of the flexible circuit board of the present invention.
Fig. 2 is a three-dimensional structural schematic diagram of the spatial layout of the flexible circuit board of the present invention, viewed from another angle.
Fig. 3 is a structural schematic diagram of an assembly relationship of the flexible circuit board and a top surface of a base in the present invention.
Fig. 4 is a structural schematic diagram of an assembly relationship of the flexible circuit board and a bottom surface of the base in the present invention.
Fig. 5 is a structural schematic diagram of an assembly relationship of the flexible circuit board and a side of the base in the present invention.

The reference labels are as follows:

| Label | Meaning |
|---|---|
| 1 | circuit board |
| 11 | control circuit board |
| 12 | power supply circuit board |
| 13 | auxiliary function circuit board |
| 2 | flexible connecting member |
| 21 | first flexible connecting member |
| 22 | second flexible connecting member |
| 3 | base |
| 31 | opening |
| 32 | accommodating space |
| 33 | locating structure |
| 34 | communication port |
| 4 | slot-type channel |
| 5 | housing |
| 51 | first housing |
| 52 | second housing |

### Particular embodiments

To enable clearer understanding of the technical features, object and effects of the present invention, particular embodiments of the present invention are now explained with reference to the accompanying drawings, in which identical labels indicate identical parts. In the drawings showing various embodiments, identical final two digits indicate components which are structurally identical, or structurally similar but functionally identical.

To make the drawings uncluttered, only parts relevant to the present invention are shown schematically in the drawings, but these do not represent the actual structure thereof as a product. Furthermore, to make the drawings uncluttered and easy to understand, with regard to components having the same structure or function in certain drawings, only one of these is drawn schematically, or only one of these is labelled.

In this text, "up", "down", "front", "rear", "left" and "right" etc. are merely used to indicate a positional relationship among relevant parts, and do not define their absolute positions.

In this text, "first" and "second" etc. are merely used for the purpose of distinguishing between components, and do not indicate their order or degree of importance, etc.

In this text, "parallel" and "perpendicular" etc. are not strict limitations in a mathematical and/or geometric sense, and also include errors which can be understood by those skilled in the art and are permitted by manufacturing or use, etc.

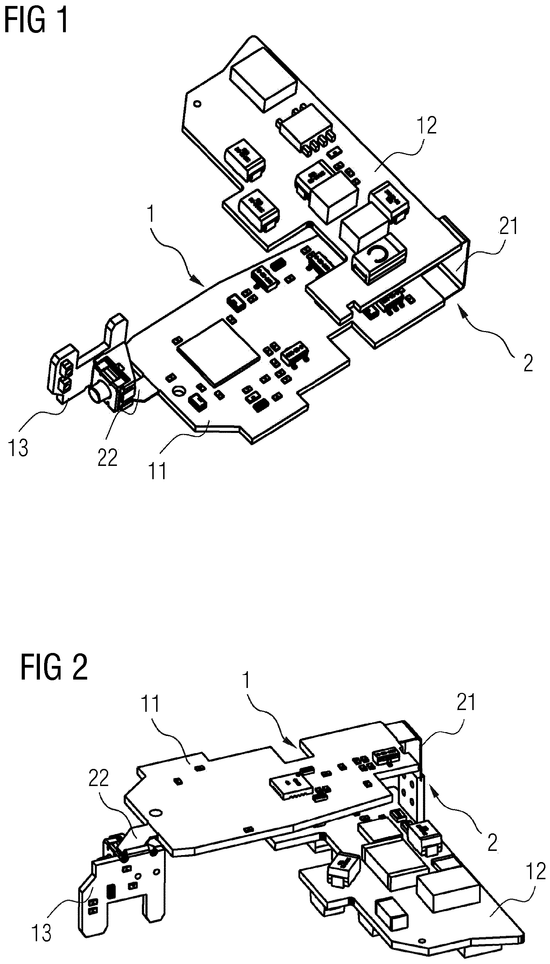

The applicants have found that in order to realize structural requirements (the circuit breaker width is only 18 mm) of a 1 MW leakage protection circuit breaker (with English abbreviation RCBO, Residual Current operated Circuit-breaker with Integral Overcurrent protection) and guarantee AFD function. Therefore the only option is to design one whole circuit board as multiple circuit boards to reduce the area and space occupied by the circuit board; if internal circuits of the circuit boards are connected by conventional connecting lines, the design of complementary structures and subsequent installation will obviously require great effort. Moreover, it is also necessary to ensure that there is a sufficient creepage distance and electrical gap in the spatial design. Fig. 1 is a three-dimensional structural schematic diagram of the spatial layout of the flexible circuit board of the present invention. As shown in fig. 1, to overcome the above shortcomings, the present application provides a flexible circuit board, comprising multiple circuit boards 1, and a flexible connecting member 2 capable of connecting the multiple circuit boards 1. An advantage of the flexible connecting member 2 is that it enables free spatial layout of multiple circuit boards 1 in a limited space, breaking through the spatial limitations of one conventional whole circuit board and ensuring that a sufficient gap is designed to enable the creepage distance and electrical gap between the multiple circuit boards 1 to meet design requirements.

To clarify the technical solution and advantages of the present invention, the present invention is explained in further detail below with reference to the accompanying drawings and embodiments. It should be understood that the particular embodiments described here are merely intended to explain the present invention elaboratively, not to limit the scope of protection thereof.

Fig. 2 is a three-dimensional structural schematic diagram of the spatial layout of the flexible circuit board of the present invention, viewed from another angle. As shown in fig. 2, in an optional embodiment, the present application provides a flexible circuit board, comprising multiple circuit boards 1 and at least one flexible connecting member 2; the circuit boards are hard circuit boards. The flexible connecting member 2 is connected between the multiple independent circuit boards 1, such that the multiple circuit boards 1 form one circuit board connected by the flexible connecting member 2; the flexible connecting member 2 is bent such that the multiple circuit boards 1 form a three-dimensional spatial layout. In this embodiment, the specific details of the spatial layout of the multiple circuit boards 1 need not be restricted. In general, the circuit board 1 is made of a hard material having a certain rigidity. The design uses hard circuit boards 1 because fitting to structural components is easier. In addition, partitioning and then disposition on different circuit boards 1 is carried out by means of the specific details of circuitry or functions as far as possible. In other words, circuit designs having the same function or which cannot easily be separated on the circuit are disposed on the same circuit board 1. Since one whole circuit board is separated into multiple pieces, it is very easy to ensure a sufficient creepage distance and electrical gap in the design.

In another optional embodiment, a connection circuit is disposed on the flexible connecting member 2; the connection circuit connects internal circuits of the multiple circuit boards 1. During actual operation, there might not be a circuit connection between the multiple circuit boards 1. In other words, in some cases, a circuit connection is not needed between the independent circuit boards 1, and the flexible connecting member 2 is merely a structural connecting member. However, in the vast majority of cases, the flexible connecting member 2 not only serves as a structural connecting member but will also be used to connect circuits between different circuit boards 1. A conventional manner of connection by conductive wires can be completely replaced, because a circuit can also be printed on the flexible connecting member 2; as long as ports for insertion with the circuit boards 1 are provided at the two ends of the flexible connecting member, connection with internal circuits of different circuit boards 1 is possible.

In another optional embodiment, the multiple circuit boards 1 comprise a control circuit board 11 and a power supply circuit board 12, and an auxiliary function circuit board 13. The flexible connecting member 2 comprises a first flexible connecting member 21 and a second flexible connecting member 22; two ends of the first flexible connecting member 21 are connected to the control circuit board 11 and the power supply circuit board 12 respectively. Two ends of the second flexible connecting member 22 are connected to the control circuit board 11 and the auxiliary function circuit board 13 respectively. This embodiment provides a specific structure of the flexible circuit board; the multiple circuit boards 1 are clearly divided into the control circuit board 11, the power supply circuit board 12 and the auxiliary function circuit board 13. Moreover, the circuit boards 1 are circuit-connected by means of the first flexible connecting member 21 and the second flexible connecting member 22. This embodiment is mainly a specific flexible circuit board specially designed for a circuit breaker subsequently described. Further illustration and explanation will be given below in conjunction with the circuit breaker; no further superfluous description is given here. Furthermore, this embodiment merely provides an example demonstratively, without defining the specific structure of the flexible circuit board.

In another optional embodiment, the control circuit board 11 and the power supply circuit board 12 are disposed opposite and parallel to each other; the auxiliary function circuit board 13 is disposed between the control circuit board 11 and the power supply circuit board 12, and is arranged perpendicular to the control circuit board 11 and the power supply circuit board 12. This embodiment provides a three-dimensional spatial layout based on the abovementioned circuit board connection structure.

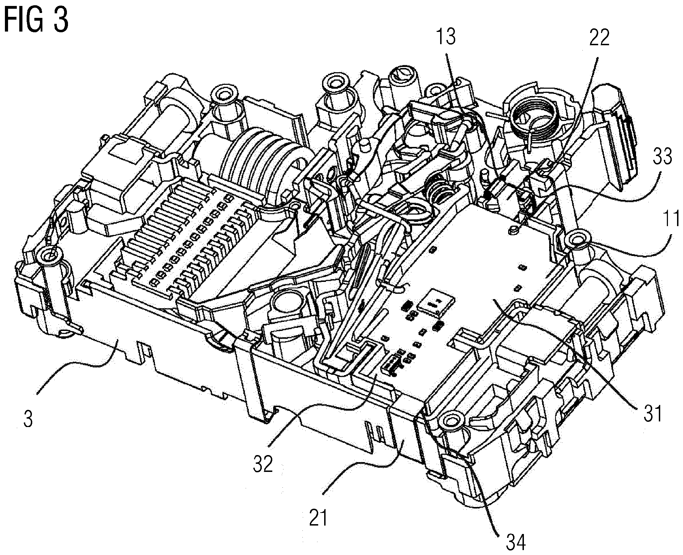

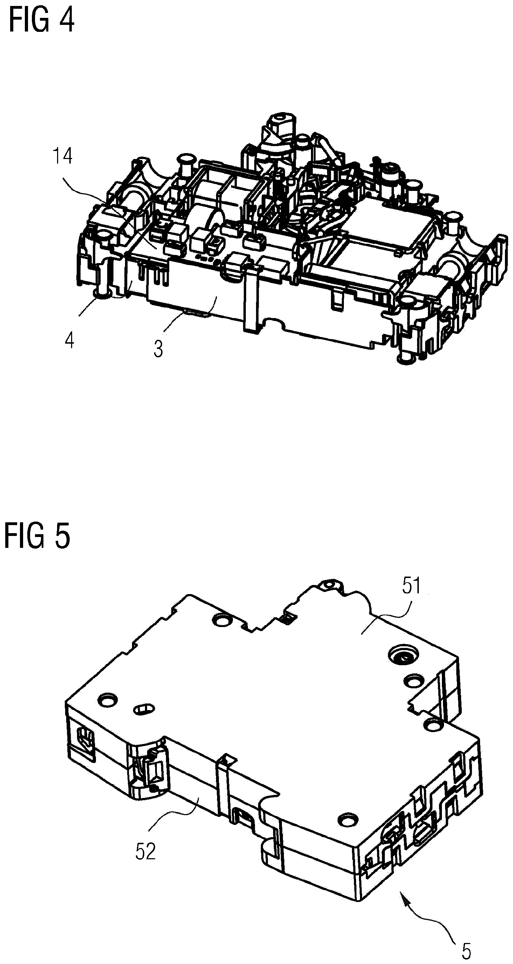

Fig. 3 is a structural schematic diagram of an assembly relationship of the flexible circuit board and a top surface of a base in the present invention; fig. 4 is a structural schematic diagram of an assembly relationship of the flexible circuit board and a bottom surface of the base in the present invention. As shown in figs. 3 to 4, in another optional embodiment, the present application also provides a circuit breaker using a flexible circuit board, comprising the flexible circuit board and a base 3; multiple circuit boards 1 are fixed at different spatial positions on the base 3, such that the multiple circuit boards 1 form a three-dimensional spatial layout. The specific layout is explained as follows in conjunction with the multiple circuit boards 1 and flexible connecting member 2 in the above embodiment: the base 3 is a rectangular structure, the control circuit board 11 is positioned flat on the top surface of the base 3 and ultimately will be fixed to the base 3, and the power supply circuit board 12 is positioned flat on the bottom surface of the base 3 and ultimately will also be fixed to the base 3. The control circuit board 11 and the power supply circuit board 12 are arranged opposite one another, spaced apart by one base 3; the first flexible connecting member 21 connects the control circuit board 11 and the power supply circuit board 12 via a side of the base 3; the auxiliary function circuit board 13 is located at a middle part of the base 3 and is inserted perpendicularly into the base 3, and is connected to the control circuit board 11 via the second flexible connecting member 22. Since the auxiliary function circuit board 13 is inserted into the base 3, a top edge thereof is substantially flush with the top surface of the base 3; this also makes it easier for the second flexible connecting member 22 to be arranged tightly against the top surface of the base 3. As can be seen, the flexible circuit board plays a very important role in the formation of the three-dimensional spatial layout. The abovementioned three-dimensional spatial layout in relation to the flexible circuit board is a demonstrative example given on the basis of a specific structure of the flexible circuit board.

In an optional embodiment, the flexible connecting member 2 is a thin-plate structure, arranged in a close fit with a surface of the base 3. This is in order to reduce its own volume and occupied space as much as possible. The flexible connecting member 2 is designed as a thin plate mainly so that, when fitted closely to the base 3, not only is design facilitated, but the space utilization rate is also increased to the greatest extent when disposition is carried out in a close fit with the base 3.

Fig. 5 is a structural schematic diagram of an assembly relationship of the flexible circuit board and a side of the base in the present invention. As shown in fig. 5, in an optional embodiment, the base 3 is provided with at least one slot-type channel 4; the slot-type channel 4 is disposed on the surface of the base 3 with which the flexible connecting member 2 is arranged in a close fit, and the slot-type channel 4 accommodates the flexible connecting member 2. Since the flexible connecting member 2 still has a certain thickness, it is in a close fit with a sidewall of the base 3 in particular like the case of the first flexible connecting member 21. The provision of the slot-type channel 4 enables the first flexible connecting member 21 to be positioned therein; this can not only protect the flexible connecting member 2 and prevent an increase in the thickness of surfaces in a close fit with each other, but also facilitates preliminary positioning when installation is carried out.

In another optional embodiment, multiple accommodating spaces 32 with outward-facing openings 31 are disposed on surfaces at different spatial positions of the base 3; the multiple circuit boards 1 are disposed in the multiple accommodating spaces 32 respectively and located by means of locating structures 33; communication ports 34 are disposed on sidewalls of the accommodating spaces 32 for the purpose of passing through and connecting the flexible connecting member 2. The circuit breaker further comprises at least one housing 5; the housing 5 is fastened to the base 3, so that the housing 5 closes the openings 31 of the accommodating spaces 32 to form closed chambers to accommodate the circuit boards 1. This embodiment discloses a specific manner of arranging the flexible circuit board in the circuit breaker. The objective thereof is not only to reduce the space occupied by the flexible circuit board as much as possible, but also to isolate the component parts of the flexible circuit board on the base 3 from each other as much as possible to form independent spaces.

In another optional embodiment, a slot-type channel 4 is disposed on an inner wall of the housing 5, in a position corresponding to the flexible connecting member; the slot-type channel 4 is used to accommodate the flexible connecting member 2. This embodiment provides a technical solution in which, in addition to having a slot-type channel 4 disposed on the base 3, a slot-type channel 4 may also be disposed on an inner wall of the housing 5.

In another optional embodiment, the multiple accommodating spaces 32 are disposed on two opposite outer surfaces of the base 3 respectively. In the figures, these are the top surface and the bottom surface of the base 3, and the at least one housing 5 further comprises: a first housing 51 and a second housing 52, the first housing 51 and the second housing 52 being fastened to the two opposite outer surfaces respectively, with inner walls of the first housing 51 and the second housing 52 abutting the openings of the accommodating spaces 32 to form the closed chambers. This embodiment further provides a specific assembly structure of the accommodating spaces 32 and the housing 5.

The present application has the following specific beneficial effects:
One whole circuit board in the prior art is separated into multiple different circuit boards 1 by means of specific requirements regarding function or circuitry. The multiple circuit boards 1 can form a three-dimensional spatial layout freely according to different assembly circumstances. Moreover, the separate circuit boards 1 are connected by means of the flexible connecting member 2. (This can be structural connection, or both structural connection and circuit connection.) The technical solution of the present application not only breaks through space restrictions, but can also provide a sufficient creepage distance and electrical gap.

The use of the thin-plate structure in the flexible connecting member 2 minimizes the space occupied thereby. The design of the slot-type channel 4 reduces the space occupied by the flexible connecting member 2 further in cooperation with the flexible circuit board.

Different accommodating spaces 32 are arranged and different circuit boards 1 are positioned separately in different accommodating spaces 32; not only is the space occupied by the flexible circuit board reduced as much as possible, but the component parts of the flexible circuit board on the base 3 are isolated from each other as much as possible to form independent spaces.

In this text, "schematic" means "serving as a real instance, an example or an illustration". No drawing or embodiment described as "schematic" herein should be interpreted as a more preferred or more advantageous technical solution.

It should be understood that although the description herein is based on various embodiments, it is by no means the case that each embodiment contains just one independent technical solution. Such a method of presentation is adopted herein purely for the sake of clarity. Those skilled in the art should consider the description in its entirety. The technical solutions in the various embodiments could also be suitably combined to form other embodiments capable of being understood by those skilled in the art.

The series of detailed explanations set out above are merely particular explanations of feasible embodiments of the present invention, which are not intended to limit the scope of protection thereof.

## Claims

1. A flexible circuit board for a circuit breaker comprising:
multiple circuit boards (1), which are hard circuit boards; and
flexible connecting members (2), connected between the independent multiple circuit boards (1), such that the multiple circuit boards (1) form a circuit board connected by the flexible connecting members (2), the flexible connecting members (2) being bent such that the multiple circuit boards (1) form a three-dimensional spatial layout, wherein a connection circuit is disposed on the flexible connecting members (2);
the connection circuit connects internal circuits of the multiple circuit boards (1); the multiple circuit boards (1) comprise:
a control circuit board (11); and
a power supply circuit board (12);
an auxiliary function circuit board (13);
**characterised in that**
the flexible connecting members (2) comprise:
a first flexible connecting member (21), two ends of the first flexible connecting member (21) being connected to the control circuit board (11) and the power supply circuit board (12) respectively;
a second flexible connecting member (22), two ends of the second flexible connecting member (22) being connected to the control circuit board (11) and the auxiliary function circuit board (13) respectively; and the three-dimensional spatial layout comprises: the auxiliary function circuit board (13) being disposed between the control circuit board (11) and the power supply circuit board (12), and being arranged perpendicular to the control circuit board (11) and the power supply circuit board (12), and
the control circuit board (11) and the power supply circuit board (12) being disposed opposite and parallel to each other.

2. A circuit breaker using a flexible circuit board, **characterized by** comprising:
the flexible circuit board as claimed in claim 1; and
a base (3), the multiple circuit boards (1) being fixed at different spatial positions on the base (3), such that the multiple circuit boards (1) form a three-dimensional spatial layout.

3. The circuit breaker using a flexible circuit board as claimed in claim 2, **characterized in that**
at least one flexible connecting member (2) is a thin-plate structure, this flexible connecting member (2) being arranged in a close fit with a surface of the base (3).

4. The circuit breaker using a flexible circuit board as claimed in claim 3, **characterized in that** the base (3) is provided with:
at least one slot-type channel (4), the slot-type channel (4) being disposed on the base (3) or surface with which at least one flexible connecting member (2) is arranged in a close fit, and the slot-type channel (4) accommodating this flexible connecting member (2).

5. The circuit breaker using a flexible circuit board as claimed in claim 2, **characterized in that** multiple accommodating spaces (32) with outward-facing openings (31) are disposed on surfaces at different spatial positions of the base (3); the multiple circuit boards (1) are disposed in the multiple accommodating spaces (32) respectively and located by means of locating structures (33); communication ports (34) are disposed on sidewalls of the accommodating spaces (32) for the purpose of passing through and connecting at least one flexible connecting member (2);
the circuit breaker further comprises:
at least one housing (5), the housing (5) being fastened to the base (3), so that the housing (5) closes the openings (31) of the accommodating spaces (32) to form closed chambers to accommodate the circuit boards (1).

6. The circuit breaker using a flexible circuit board as claimed in claim 5, **characterized in that** a slot-type channel (4) is disposed on an inner wall of the housing (5), in a position corresponding to at least one flexible connecting member (2); the slot-type channel (4) is used to accommodate this flexible connecting member (2).

7. The circuit breaker using a flexible circuit board as claimed in claim 5, **characterized in that** the multiple accommodating spaces (32) are disposed on two opposite outer surfaces of the base (3) respectively;
the at least one housing (5) further comprises:
a first housing (51); and
a second housing (52), the first housing (51) and the second housing (52) being fastened to the two opposite outer surfaces respectively, with inner walls of the first housing (51) and the second housing (52) abutting the openings of the accommodating spaces (32) to form the closed chambers.

## Patentansprüche

1. Flexible Platine für einen Schutzschalter, die Folgendes umfasst:
mehrere Platinen (1), bei denen es sich um feste Platinen handelt, und
flexible Verbindungselemente (2), die so mit den mehreren eigenständigen Platinen (1) verbunden sind, dass diese eine über die flexiblen Verbindungselemente (2) verbundene Platine bilden, wobei die flexiblen Verbindungselemente (2) so gebogen sind, dass die mehreren Platinen (1) eine dreidimensionale räumliche Anordnung bilden, wobei an den flexiblen Verbindungselementen (2) eine Verbindungsschaltung angeordnet ist,
wobei die Verbindungsschaltung interne Schaltungen der mehreren Platinen (1) verbindet, wobei die mehreren Platinen (1) Folgendes umfassen:
eine Steuerplatine (11) und
eine Stromversorgungsplatine (12),
eine Hilfsfunktionsplatine (13),
**dadurch gekennzeichnet, dass**
die flexiblen Verbindungselemente (2) Folgendes umfassen:
ein erstes flexibles Verbindungselement (21), wobei zwei Enden des ersten flexiblen Verbindungselements (21) mit der Steuerplatine (11) beziehungsweise der Stromversorgungslplatine (12) verbunden sind,
ein zweites flexibles Verbindungselement (22), wobei zwei Enden des zweiten flexiblen Verbindungselements (22) mit der Steuerplatine (11) beziehungsweise der Hilfsfunktionsplatine (13) verbunden sind, und
die dreidimensionale räumliche Anordnung Folgendes umfasst:
dass die Hilfsfunktionsplatine (13) zwischen und senkrecht zu der Steuerplatine (11) und der Stromversorgungsplatine (12) angeordnet ist und die Steuerplatine (11) und die Stromversorgungsplatine (12) einander gegenüber und parallel zueinander angeordnet sind.

2. Schutzschalter mit einer flexiblen Platine, **dadurch gekennzeichnet, dass** er Folgendes umfasst:
die flexible Platine nach Anspruch 1 und
einen Sockel (3), wobei die mehreren Platinen (1) in verschiedenen räumlichen Positionen so an dem Sockel (3) befestigt sind, dass sie eine dreidimensionale räumliche Anordnung bilden.

3. Schutzschalter mit einer flexiblen Platine nach Anspruch 2, **dadurch gekennzeichnet, dass**
es sich bei mindestens einem flexiblen Verbindungselement (2) um eine dünne Platinenkonstruktion handelt, wobei dieses flexible Verbindungselement (2) eng an einer Oberfläche des Sockels (3) anliegend angeordnet ist.

4. Schutzschalter mit einer flexiblen Platine nach Anspruch 3, **dadurch gekennzeichnet, dass** der Sockel (3) mit Folgendem versehen ist:
mindestens einem schlitzartigen Kanal (4), der an dem Sockel (3) oder der Oberfläche angeordnet ist, an der mindestens ein flexibles Verbindungselement (2) eng anliegend angeordnet ist, und dieses flexible Verbindungselement (2) aufnimmt.

5. Schutzschalter mit einer flexiblen Platine nach Anspruch 2, **dadurch gekennzeichnet, dass** an Oberflächen in verschiedenen räumlichen Positionen an dem Sockel (3) mehrere Aufnahmen (32) mit nach außen weisenden Öffnungen (31) angeordnet sind, die mehreren Platinen (1) jeweils in den mehreren Aufnahmen (32) angeordnet sind und mithilfe von Positionierkonstruktionen (33) positioniert werden, an Seitenwänden der Aufnahmen (32) Kommunikationsanschlüsse (34) zu dem Zweck angeordnet sind, dass sie dort hindurchgehen und mindestens ein flexibles Verbindungselement (2) verbinden,
der Schutzschalter ferner Folgendes umfasst:
mindestens ein Gehäuse (5), das so an dem Sockel (3) befestigt ist, dass es die Öffnungen (31) der Aufnahmen (32) schließt und so geschlossene Kammern zum Aufnehmen der Platinen (1) entstehen.

6. Schutzschalter mit einer flexiblen Platine nach Anspruch 5, **dadurch gekennzeichnet, dass** an einer Innenwand des Gehäuses (5) in einer Position, die mindestens einem flexiblen Verbindungselement (2) entspricht, ein schlitzartiger Kanal (4) angeordnet ist, der schlitzartige Kanal (4) zum Aufnehmen dieses flexiblen Verbindungselements (2) dient.

7. Schutzschalter mit einer flexiblen Platine nach Anspruch 5, **dadurch gekennzeichnet, dass** die mehreren Aufnahmen (32) jeweils an zwei sich gegenüberliegenden Außenflächen des Sockels (3) angeordnet sind,
das mindestens eine Gehäuse (5) ferner Folgendes umfasst:
ein erstes Gehäuse (51) und
ein zweites Gehäuse (52), wobei das erste Gehäuse (51) und das zweite Gehäuse (52) jeweils an den beiden sich gegenüberliegenden Außenfläche befestigt sind, wobei Innenwände des ersten Gehäuses (51) und des zweiten Gehäuses (52) an den Öffnungen der Aufnahmen (32) anliegen und so die geschlossenen Kammern bilden.

## Revendications

1. Carte de circuit imprimé flexible pour un disjoncteur comprenant :
plusieurs cartes de circuit imprimé (1), qui sont des cartes de circuit imprimé dures ; et
des éléments de connexion flexibles (2), connectés entre les plusieurs cartes de circuit imprimé (1) indépendantes, de sorte que les plusieurs cartes de circuit imprimé (1) forment un circuit imprimé connecté par les éléments de connexion flexibles (2), les éléments de connexion flexibles (2) étant pliés de sorte que les plusieurs cartes de circuit imprimé (1) forment une disposition spatiale tridimensionnelle, dans laquelle un circuit de connexion est disposé sur les éléments de connexion flexibles (2) ;
le circuit de connexion relie les circuits internes des plusieurs cartes de circuit imprimé (1) ; les plusieurs cartes de circuit imprimé (1) comprennent :
une carte de circuit imprimé de commande (11) ; et
une carte de circuit imprimé d'alimentation (12) ;
une carte de circuit imprimé de fonction auxiliaire (13) ;
**caractérisé en ce que**
les éléments de connexion flexibles (2) comprennent un premier élément de connexion flexible (21), deux extrémités du premier élément de connexion flexible (21) étant connectées respectivement à la carte de circuit imprimé de commande (11) et à la carte de circuit imprimé d'alimentation (12) ;
un deuxième élément de connexion flexible (22), deux extrémités du deuxième élément de connexion flexible (22) étant connectées à la carte de circuit imprimé de commande (11) et à la carte de circuit imprimé de fonction auxiliaire (13) respectivement ; et la disposition spatiale tridimensionnelle comprend : la carte de circuit imprimé de fonction auxiliaire (13) étant disposée entre la carte de circuit imprimé de commande (11) et la carte de circuit imprimé d'alimentation (12), et étant disposée perpendiculairement à la carte de circuit imprimé de commande (11) et à la carte de circuit imprimé d'alimentation (12), et la carte de circuit imprimé de commande (11) et la carte de circuit imprimé d'alimentation (12) étant disposées à l'opposé et parallèlement l'une à l'autre.

2. Disjoncteur utilisant une carte de circuit imprimé flexible, **caractérisé en ce qu'**il comprend :
la carte de circuit imprimé flexible selon la revendication 1 ; et
une base (3), les plusieurs cartes de circuit imprimé (1) étant fixées à différentes positions spatiales sur la base (3), de sorte que les plusieurs cartes de circuit imprimé (1) forment une disposition spatiale tridimensionnelle.

3. Disjoncteur utilisant une carte de circuit imprimé flexible selon la revendication 2,
**caractérisé en ce qu'**au moins un élément de connexion flexible (2) est une structure à plaques minces, cet élément de connexion flexible (2) étant disposé de manière à s'ajuster étroitement à une surface de la base (3).

4. Disjoncteur utilisant une carte de circuit imprimé flexible selon la revendication 3,
**caractérisé en ce que** la base (3) est pourvue de :
au moins un canal de type fente (4), le canal de type fente (4) étant disposé sur la base (3) ou la surface avec laquelle l'au moins un élément de connexion flexible (2) est disposé en ajustement serré, et le canal de type fente (4) accueillant cet élément de connexion flexible (2).

5. Disjoncteur utilisant une carte de circuit imprimé flexible selon la revendication 2,
**caractérisé en ce que** plusieurs espaces de logement (32) avec des ouvertures (31) orientées vers l'extérieur sont disposés sur des surfaces à différentes positions spatiales de la base (3) ; les plusieurs cartes de circuit imprimé (1) sont disposées dans les plusieurs espaces de logement (32) respectivement et localisées au moyen de structures de localisation (33) ; des ports de communication (34) sont disposés sur les parois latérales des espaces de logement (32) dans le but de traverser et de connecter au moins un élément de connexion flexible (2) ;
le disjoncteur comprend en outre :
au moins un boîtier (5), le boîtier (5) étant fixé à la base (3), de sorte que le boîtier (5) ferme les ouvertures (31) des espaces de logement (32) pour former des chambres fermées destinées à recevoir les cartes de circuit imprimé (1).

6. Disjoncteur utilisant une carte de circuit imprimé flexible selon la revendication 5,
**caractérisé en ce qu'**un canal de type fente (4) est disposé sur une paroi intérieure du boîtier (5), dans une position correspondant à au moins un élément de connexion flexible (2) ; le canal de type fente (4) est utilisé pour accueillir cet élément de connexion flexible (2).

7. Disjoncteur utilisant une carte de circuit imprimé flexible selon la revendication 5,
**caractérisé en ce que** les plusieurs espaces de logement (32) sont disposés sur deux surfaces extérieures opposées de la base (3) respectivement ;
l'au moins un boîtier (5) comprend en outre :
un premier boîtier (51) ; et
un deuxième boîtier (52), le premier boîtier (51) et le deuxième boîtier (52) étant fixés respectivement aux deux surfaces extérieures opposées, les parois intérieures du premier boîtier (51) et du deuxième boîtier (52) venant buter contre les ouvertures des espaces de logement (32) pour former les chambres fermées.
